# EUROPEAN PATENT APPLICATION

(11) **EP 2 765 603 A2**
(43) Date of publication of application: **13.08.2014**
(21) Application number: 14154000.5
(22) Date of filing: 05.02.2014
(51) Int. Cl.: H01L 27/00

(54) **Three-dimensional monolithic electronic-photonic integrated circuit**

(30) Priority: 06.02.2013 KR 20130013487
(71) Applicant: Samsung Electronics Co., Ltd, Gyeonggi-do 443-742 (KR)
(72) Inventor: Cho, Seong-ho, Gyeonggi-do (KR)
(74) Representative: Greene, Simon Kenneth

(57) **Abstract**

A three-dimensional monolithic electronic-photonic integrated circuit and a method of manufacturing the same. The electronic-photonic integrated circuit (200) may include a photonic element (260) formed in a sealed space of a substrate and an electronic element (270) formed on the substrate. The substrate may include a first substrate (210) and a second substrate (252) that are bonded to each other. The first substrate (210) having a first trench (212) corresponding to the sealed space formed therein, a first surface of the second substrate (252) having the photonic element formed thereon, and the sealed space defined by a space formed inside the first trench that is sealed by the first surface of the second substrate.

## Description

### FIELD OF THE INVENTION

Example embodiments relate to an electronic-photonic integrated circuit in which a photonic element and an electronic element are three-dimensionally formed monolithically.

### BACKGROUND OF THE INVENTION

Semiconductor integrated circuits are integrated on printed circuit board and may utilize electronic and/or optical communications to transmit and receive data.

Semiconductor integrated circuits may perform electric communication through interconnections. However, due to limitations in reducing electric resistance between the semiconductor integrated circuits, it is difficult to increase communication speeds when utilizing electronic communications.

Recently, to improve communication speeds between the semiconductor integrated circuits, optical interconnection or optical communication has been adopted. The optical communication transmits and/or receives an optical signal that includes information stored therein. The optical communication has less interference from external electromagnetic waves and achieves higher communication speed than electric communication.

### SUMMARY OF THE INVENTION

Provided is a three-dimensional monolithic electronic-photonic integrated circuit in which a photonic element is formed under a substrate bonded onto a support substrate and an electronic element is formed on the substrate.

Additional example embodiments will be set forth in part in the description which follows and, in part, will be apparent from the description, or may be learned by practice of the presented embodiments.

According to an example embodiment, an electronic-photonic integrated circuit includes a photonic element formed in a sealed space of a substrate and an electronic element formed on the substrate.

The substrate may include a first substrate and a second substrate that are bonded to each other The first substrate having a first trench corresponding to the sealed space formed therein, and a first surface of the second substrate having the photonic element formed thereon, and the sealed space defined by a space formed inside the first trench that is sealed by the first surface of the second substrate.

According to an example embodiment, the electronic element may include a switching element electrically connected to the photonic element, the switching element may be disposed on a second surface of the second substrate that faces opposite the first surface of the second substrate having the photonic element disposed thereon.

The electronic-photonic integrated circuit may further include a metal via formed in the second substrate, the metal via configured to electrically connect the switching element with the photonic element.

The electronic element may further include a complementary metal oxide semiconductor (CMOS) element formed on the second surface of the second substrate in a region adjacent to a region in which the photonic element is disposed, and the first substrate may further include a second trench formed in a region therein to vertically correspond to the region of the second substrate having the CMOS element formed thereon.

The first trench may have a depth that is deeper than a depth of the second trench.

The second trench may have a depth of about 1 nm - 200 nm.

According to another example embodiment, the electronic element may include a switching element and a complementary metal oxide semiconductor (CMOS) element that are formed on a second surface of the second substrate facing opposite the first surface of the second substrate in a region that is adjacent to a region in which the photonic element is formed, and a second trench is formed in the first substrate under the electronic element.

The electronic-photonic integrated circuit may further include an insulating layer formed on the substrate such that the insulating layer covers the electronic element, and further include a plurality of metal vias formed in the insulating layer, the plurality of metal vias configured to electrically connect the electronic element and the photonic element.

The substrate may be formed of silicon or a III-V group semiconductor.

According to another example embodiment, an electronic-photonic integrated circuit includes a first substrate including a first surface and a second surface, the second surface facing a direction opposite a direction that the first surface faces, a photonic element formed on the first surface, and an electronic element formed on the second surface.

The electronic-photonic integrated circuit may further include a second substrate that is bonded to the first surface of the first substrate, the second substrate including a first trench configured to enclose the photonic element therein.

At least one example embodiment relates to an integrated circuit.

The invention also relates to a method of manufacturing an electronic-photonic integrated circuit comprising:
providing a first substrate including a first surface and a second surface, the second surface facing a direction opposite a direction that the first surface faces, a photonic element on the first surface; and an electronic element on the second surface; and
bonding a second substrate bonded to the first surface of the first substrate, the second substrate including a first trench configured to enclose the photonic element therein.

### BRIEF DESCRIPTION OF THE DRAWINGS

These and/or other example embodiments will become apparent and more readily appreciated from the following description of the embodiments, taken in conjunction with the accompanying drawings in which:
FIGS. 1A through 1F are diagrams for describing a method of manufacturing a three-dimensional monolithic electronic-photonic integrated circuit according to an example embodiment;
FIGS. 2A through 2F are diagrams for describing a method of manufacturing a three-dimensional monolithic electronic-photonic integrated circuit according to another example embodiment; and
FIGS. 3A and 3B are diagrams for describing a method of manufacturing a three-dimensional monolithic electronic-photonic integrated circuit according to still another example embodiment.

### DETAILED DESCRIPTION

Hereinafter, embodiments of the present disclosure will be described with reference to the accompanying drawings. In the drawings, identical reference numerals refer to identical components, and sizes and thicknesses of the components may be exaggerated for clarity of the description. Throughout the specification, substantially identical components will be referred to by using identical reference numerals and will not be described repetitively.

Example embodiments will now be described more fully with reference to the accompanying drawings, in which some example embodiments are shown. In the drawings, the thicknesses of layers and regions are exaggerated for clarity. Like reference numerals in the drawings denote like elements.

Detailed illustrative embodiments are disclosed herein. However, specific structural and functional details disclosed herein are merely representative for purposes of describing example embodiments. Example embodiments may be embodied in many alternate forms and should not be construed as limited to only those set forth herein.

It should be understood, however, that there is no intent to limit this disclosure to the particular example embodiments disclosed. On the contrary, example embodiments are to cover all modifications, equivalents, and alternatives falling within the scope of the invention. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of this disclosure. As used herein, the term "and/or," includes any and all combinations of one or more of the associated listed items.

It will be understood that when an element is referred to as being "connected," or "coupled," to another element, it can be directly connected or coupled to the other element or intervening elements may be present. In contrast, when an element is referred to as being "directly connected," or "directly coupled," to another element, there are no intervening elements present. Other words used to describe the relationship between elements should be interpreted in a like fashion (e.g., "between," versus "directly between," "adjacent," versus "directly adjacent," etc.).

The terminology used herein is for the purpose of describing particular embodiments only and is not intended to be limiting. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

It should also be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

Various example embodiments will now be described more fully with reference to the accompanying drawings in which some example embodiments of the invention are shown. In the drawings, the thicknesses of layers and regions are exaggerated for clarity.

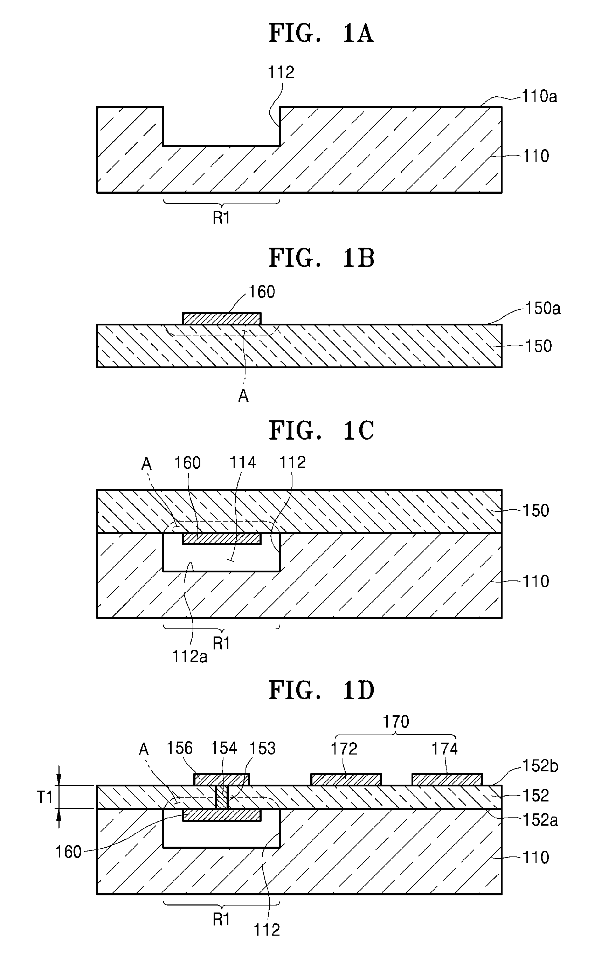

FIGS. 1A through 1 F are diagrams for describing a method of manufacturing a three-dimensional monolithic electronic-photonic integrated circuit 100 step-by-step according to an example embodiment.

Referring to FIG. 1A, a wafer may be provided that includes a plurality of chip areas. A region included in one chip area is illustrated briefly in FIGS. 1A through 1 F and will be referred to as a first substrate 110.

The first substrate 110 may be formed of silicon (Si) or an III-V group material. The first substrate 110 is also referred to as a support substrate.

First, on the first substrate 110, a photonic element region R1 on which a photonic element is to be formed is confined. On a first surface 110a of the first substrate 110, a trench 112 is formed in the photonic element region R1. Formation of the trench 112 may use general photolithography processing and, therefore, will not be described in detail. The trench 112 may be formed to a depth that provides a space for receiving the photonic element described below. For example, the trench 112 may be formed to have a depth of 100 nm or more.

Referring to FIG. 1 B, a second substrate 150 is provided. The second substrate 150 may be formed of Si or an III-V group material. On a first surface 150a of the second substrate 150, a photonic element 160 is formed on a region corresponding to the photonic element region R1. A plurality of photonic elements may be formed on the first surface 150a, but in the current embodiment, one photonic element has been illustrated for convenience. In a process of forming the photonic element 160, p-doping and n-doping are performed, such that a surface region A of the second substrate 150 connected to the photonic element 160 may be doped with impurities. That is, the surface region A may be a conductive region. The photonic element 160 may be a laser diode, a light emitting diode, an optical modulator, a multiplexer, a demultiplexer, a photo diode, or a waveguide.

Referring to FIG. 1C, the second substrate 150 is bonded onto the first substrate 110 in such a way that the photonic element 160 faces a bottom 112a of the trench 112. For the bonding, plasma bonding may be used. The trench 112 forms a specific sealed space 114 by the bonding between the first substrate 110 and the second substrate 150, and the photonic element 160 is disposed in the space 114.

Referring to FIG. 1D, the second substrate 150 is thinned to form a thinned second substrate 152 having a thickness T1 of about 10 nm - 200 nm. Thinning may include primarily performing mechanical grinding or wet chemical etching and then performing chemical mechanical polishing (CMP).

An electronic element 170 is formed on a second surface 152b of the thinned second substrate 152. The second surface 152b faces opposite the first surface 152a with respect to the thinned second substrate 152. The electronic element 170 may be formed on a first region next to the photonic element region R1. The electronic element 170 may include a switching element 172 for the photonic element 160 and a complementary metal oxide semiconductor (CMOS) element 174 connected to the switching element 172. The CMOS element 174 may be a dynamic random access memory (DRAM), a central processing unit (CPU), large scale integration (LSI), or a system-on-chip (SoC).

For electric connection of the photonic element 160, a via 153 is formed in the second substrate 152 and is filled with metal to form a first metal via 154. An electrode pad 156 is formed on the second substrate 152 to be connected to the first metal via 154.

Although the via 153, which passes through the second substrate 152, is formed in FIG. 1D, a via may be formed to a shallow depth and filled with metal to connect the metal via with the conductive region A. If the conductive region A is formed to reach the second surface 152b and contact the electrode pad 156, the photonic element 160 and the electrode pad 156 may be electrically connected by the conductive region A without a need to form the via and the via metal.

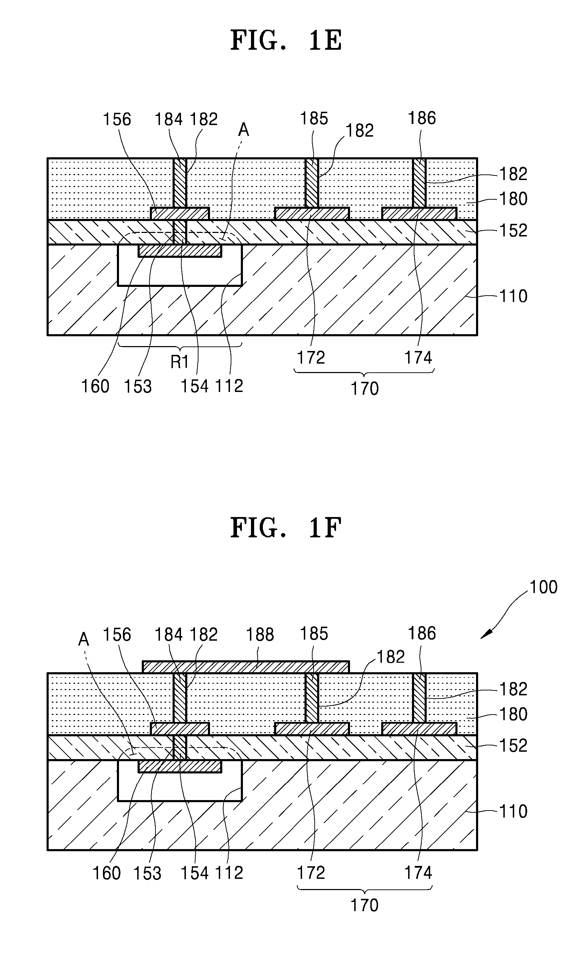

Referring to FIG. 1 E, an insulating layer 180 is formed on the second substrate 152. The insulating layer 180 may be a silicon oxide layer. The insulating layer 180 may be an interlayer dielectric.

Next, vias 182, which expose the electrode pad 156, the switching element 172, and the CMOS element 174, are formed in the insulating layer 180, and then the vias 182 are filled with metal to form a second metal via 184, a third metal via 185, and a fourth metal via 186. The metal vias 184 through 186 connect the photonic element 160 and the electronic elements 172 and 174 to an external power source.

The insulating layer 180 may confine light and reduce a propagation loss.

Referring to FIG. 1 F, a metal interconnection 188, which connects the second metal via 184 connected to the photonic element 160 with the third metal via 185 connected to the switching element 172, is formed. Thus, forming an electronicphotonic integrated circuit 100.

Processes shown in FIGS. 1 E and 1 F may be repeated with the formation of the electronic element 170, such that a plurality of insulating layers including metal vias may be formed, and an electrode pad between the adjacent insulating layers may be electrically connected to metal vias in the insulating layers thereon and thereunder.

In the electronic-photonic integrated circuit 100, the photonic element 160 is disposed on one surface of the thinned second substrate 152, where the electronic element 170 is disposed on another surface of the thinned second substrate 152, and the photonic element 160 and the electronic element 170 are monolithically formed. The three-dimensional monolithic electronic-photonic integrated circuit 170 having such a structure provides an improved integration degree and a simplified manufacturing process.

Moreover, the space 114 formed under the photonic element 160 and the insulating layer 180 formed on the photonic element 160 confines light, thereby reducing a propagation loss.

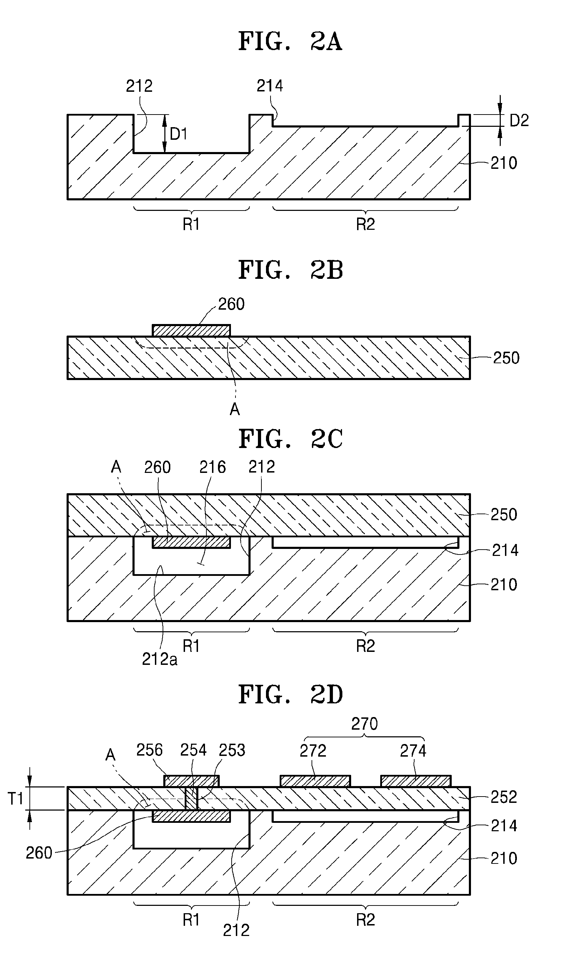

FIGS. 2A through 2F are diagrams for describing a method of manufacturing a three-dimensional monolithic electronic-photonic integrated circuit step-by-step according to another example embodiment.

Referring to FIG. 2A, a wafer is provided. The wafer includes a plurality of chip areas. In FIGS. 2A through 2F, a region included in one chip area is illustrated briefly, and will be referred to as a first substrate 210.

The first substrate 210 may be formed of Si or an III-V group material.

First, on the first substrate 210, a photonic element region R1 on which a photonic element is to be formed and an electronic element region R2 on which an electronic element is to be formed are confined. However, another electronic element may also be formed on regions other than R1 and R2.

A first trench 212 is formed on the photonic element region R1 of the first substrate 210. A depth D1 of the first trench 212 may be about 0.1 µm - about 3 µm. Formation of the first trench 212 may use a general photolithography process and will not be described in detail. The first trench 212 may be formed to a depth that provides a space for receiving a photonic element described below.

Next, a second trench 214 is formed in the photonic element region R2. A depth D2 of the second trench 214 may be about 1 nm - 200 nm such that electric charge leakage from the electronic circuit may be avoided while providing an efficient amount of heat emission and reduction in parasitic capacitance from the electronic circuit, such that a high-speed operation of the electronic circuit may be performed.

Formation of the second trench 214 may use a general photolithography process and thus will not be described in detail.

Referring to FIG. 2B, a second substrate 250 is provided. On the second substrate 250, a photonic element 260 is formed on a region corresponding to the photonic element region R1. In a process of forming the photonic element 260, p-doping and n-doping are performed, such that a surface region A of the second substrate 250 connected to the photonic element 260 may be doped with impurities. That is, the surface region A may be a conductive region. The photonic element 260 may be a laser diode, a light emitting diode, an optical modulator, a multiplexer, a demultiplexer, a photo diode, or a waveguide.

Referring to FIG. 2C, the second substrate 250 is bonded onto the first substrate 210 in such a way that the photonic element 260 faces a bottom 212a of the trench 212. The bonding may be performed using plasma bonding. The trench 212 forms a specific sealed space 216 by the bonding between the first substrate 210 and the second substrate 250, and the photonic element 260 is disposed in the space 216.

Referring to FIG. 2D, the second substrate 250 is thinned to form a second substrate 252 having a thickness T1 of about 10 nm - 200 nm. Thinning may include primarily performing mechanical grinding or wet chemical etching and then performing CMP.

On the second substrate 252, an electronic element 270 is formed above the second trench 214. Thus, the photonic element 260 is formed on one surface of the second substrate 252, and the electronic element 270 is formed on another surface of the second substrate 252. The electronic element 270 may be formed on an electronic element region R2 next to the photonic element region R1. The electronic element 270 may include a switching element 272 for the photonic element 260 and a CMOS element 274 connected to the switching element 272. The CMOS element 274 may be a DRAM, a CPU, LSI, or a SoC.

For electric connection of the photonic element 260, a via 253 is formed in the second substrate 252 and is filled with metal to form first metal via 254. An electrode pad 256 electrically connected to the first metal via 254 is formed on the second substrate 252.

Although the via 253, which passes through the second substrate 252, is formed in FIG. 2D, a via may be formed to a shallow depth and filled with metal to connect the metal via with the conductive region A. If the conductive region A is formed to contact the photonic element 260 and the electrode pad 256, the photonic element 260 and the electrode pad 256 may be electrically connected by the conductive region A without a need to form the via 253 and the metal via 254.

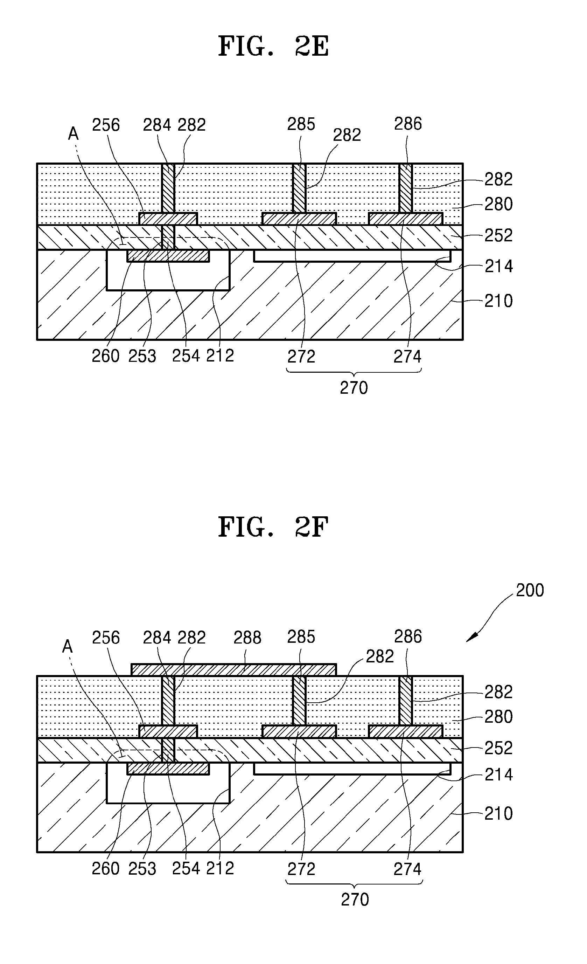

Referring to FIG. 2E, an insulating layer 280 is formed on the second substrate 252. The insulating layer 280 may be a silicon oxide layer. The insulating layer 280 may be an interlayer dielectric.

Next, vias 282, which expose the electrode pad 256, the switching element 272, and the CMOS element 274, are formed in the insulating layer 280, and then the vias 282 are filled with metal to form a second metal via 284, a third metal via 285, and a fourth metal via 286.

The insulating layer 280 may confine light and reduce a propagation loss.

Referring to FIG. 2F, a metal interconnection 288, which connects the second metal via 284 connected to the photonic element 260 with the third metal via 285 connected to the switching element 272, is formed. Thus, forming an electronic-photonic integrated circuit 200.

Processes shown in FIGS. 2E and 2F may be repeated with the formation of the electronic element 270 such that a plurality of insulating layers including metal vias may be formed, and an electrode pad between the adjacent insulating layers may be electrically connected to metal vias in the insulating layers thereon and thereunder.

In the above-described electronic-photonic integrated circuit 200, the first trench 212 and the insulating layer 280 may be formed to have thicknesses for optimizing performance of the photonic element 260, and the second trench 214 is formed for performance optimization of the electronic element 270, making it possible to achieve a high-speed operation of the electronic element 270 formed on the second trench 214.

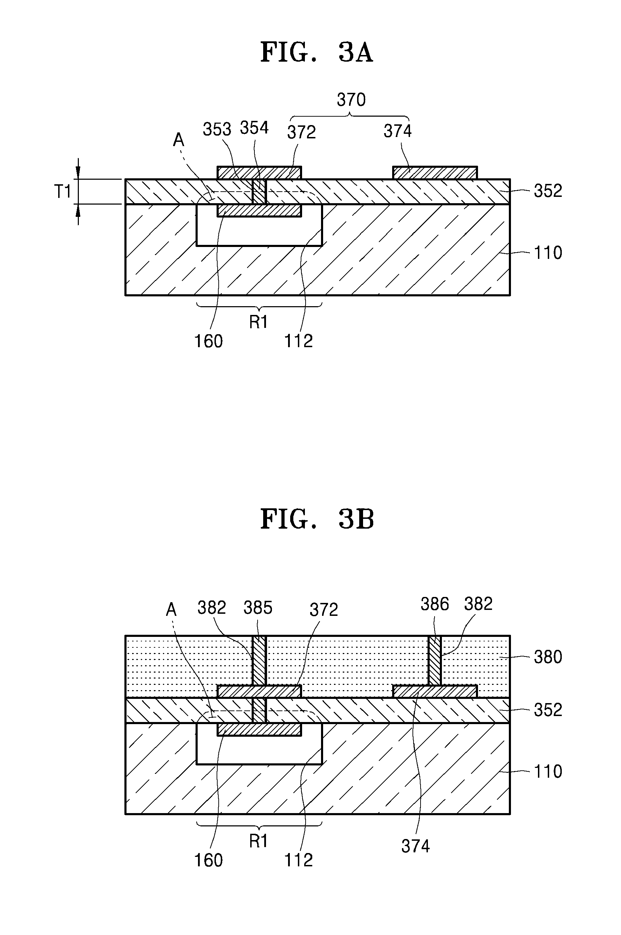

FIGS. 3A and 3B are diagrams for describing a method of manufacturing a three-dimensional monolithic electronic-photonic integrated circuit step-by-step according to still another example embodiment.

Some processes of the current embodiment are substantially the same as those of FIGS. 1A through 1C, and thus will not be described in detail.

Referring to FIG. 3A, an electronic element 370 is formed on a second substrate 352. The substrate 352 may have been thinned by performing mechanical grinding or wet chemical etching and then performing CMP to have a thickness T1 of about 10 nm - 200 nm. In the second substrate 352, a via 353 may be formed on a photonic element 160 disposed in a surface region A, and the via 353 may be filled with metal to form a first metal via 354. As stated previously, the via 353 and the first metal via 354 may be omitted by extending the surface region A.

The electronic element 370 may include a switching element 372 in a photonic element region R1 and a CMOS element 374 connected to the switching element 372 and the CMOS element 374 may be in a region next to the photonic element region R1. The CMOS element 374 may be a DRAM, a CPU, LSI, or a SoC.

Referring to FIG. 3B, an insulating layer 380 is formed on the second substrate 352. The insulating layer 380 may be a silicon oxide layer. The insulating layer 380 may be an interlayer dielectric.

Next, vias 382, which expose the switching element 372 and the electronic element 374, are formed in the insulating layer 380, and then the vias 382 are filled with metal to form a second metal via 385 and a third metal via 386.

The insulating layer 380 may confine light and reduces a propagation loss.

The process of FIG. 3B may be repeated with the formation of the electronic element 370 of FIG. 3A, and detailed description will be omitted.

In the current embodiment, the second trench 214 shown in FIG. 2C may be further formed under the CMOS element 374 on the top surface of the first substrate 110, which will not be described herein.

In the above-described electronic-photonic integrated circuit 300, due to a short interconnection that connects the photonic element 160 with the switching element 372, high-speed operation is possible and power consumption is reduced.

While example embodiments have been described with reference to example embodiments shown in the accompanying drawings, it is merely illustrative, and it will be understood by those of ordinary skill in the art that various changes and equivalent other embodiments may be made therefrom. Accordingly, the true scope of the example embodiments should be defined by the following claims.

## Claims

1. An electronic-photonic integrated circuit comprising:
a photonic element in a sealed space of a substrate; and
an electronic element on the substrate.

2. The electronic-photonic integrated circuit of claim 1, wherein the substrate includes a first substrate and a second substrate bonded to each other,
the first substrate having a first trench, and
a first surface of the second substrate having the photonic element thereon, and
the second substrate being bonded to the first substrate such that the photonic element on the first surface of the second substrate is within the first trench, such that the sealed space is defined by the space inside the first trench and sealed by the first surface of the second substrate.

3. The electronic-photonic integrated circuit of claim 2, wherein the photonic element is spaced apart from a bottom surface of the first trench.

4. The electronic-photonic integrated circuit of claim 3, wherein the electronic element includes a switching element electrically connected to the photonic element, the switching element on a second surface of the second substrate that faces opposite the first surface of the second substrate having the photonic element thereon.

5. The electronic-photonic integrated circuit of claim 4, further comprising:
a metal via in the second substrate, the metal via configured to electrically connect the switching element with the photonic element.

6. The electronic-photonic integrated circuit of claim 4 or 5, wherein
the electronic element further includes a complementary metal oxide semiconductor (CMOS) element formed on the second surface of the second substrate in a region adjacent to a region in which the photonic element is disposed, and
the first substrate further includes a second trench in a region therein to vertically correspond to the region of the second substrate having the CMOS element thereon.

7. The electronic-photonic integrated circuit of claim 6, wherein the first trench has a depth that is deeper than a depth of the second trench.

8. The electronic-photonic integrated circuit of claim 6 or 7, wherein the depth of second trench is between 1 nm and 200 nm.

9. The electronic-photonic integrated circuit of claim 2, wherein
the electronic element includes a switching element and a complementary metal oxide semiconductor (CMOS) element that are on a second surface of the second substrate facing opposite the first surface of the second substrate in a region that is adjacent to a region in which the photonic element is formed, and
a second trench is in the first substrate under the electronic element.

10. The electronic-photonic integrated circuit of any preceding claim, further comprising:
an insulating layer on the substrate such that the insulating layer covers the electronic element.

11. The electronic-photonic integrated circuit of claim 10, further comprising:
a plurality of metal vias in the insulating layer, the plurality of metal vias configured to electrically connect the electronic element and the photonic element.

12. The electronic-photonic integrated circuit of any preceding claim, wherein the substrate is silicon or a III-V group semiconductor.

13. A method of manufacturing an electronic-photonic integrated circuit comprising:
providing a first substrate including a first surface and a second surface, the second surface facing a direction opposite a direction that the first surface faces, a photonic element on the first surface; and an electronic element on the second surface; and
bonding a second substrate bonded to the first surface of the first substrate, the second substrate including a first trench configured to enclose the photonic element therein.

14. The method of manufacturing an electronic-photonic integrated circuit of claim 13, wherein
the electronic element includes:
a switching element electrically connected to the photonic element, the switching element on the second surface of the first substrate such that the switching element faces the photonic element, and
a complementary metal oxide semiconductor (CMOS) element in a region that is adjacent to a region in which the photonic element is formed, and
a second trench in the second substrate under the CMOS element,
and optionally wherein the first trench has a depth deeper than a depth of the second trench,
and further optionally wherein the depth of the second trench is between 1 nm and 200 nm.

15. The method of manufacturing an electronic-photonic integrated circuit of claim 13 , wherein
the electronic element includes a switching element and a complementary metal oxide semiconductor, CMOS, element that are in a region that is adjacent to a region in which the photonic element is formed, and
a second trench is in the second substrate under the electronic element.
